# NEUE EUROPÄISCHE PATENTSCHRIFT

(11) **EP 2 687 823 B2**
(45) Veröffentlichungstag und Bekanntmachung des Hinweises auf die Entscheidung über den Einspruch: **12.10.2022**
(45) Hinweis auf die Patenterteilung: 23.11.2016
(21) Anmeldenummer: 13002928.3
(22) Anmeldetag: 06.06.2013
(51) Int. Cl.: G01D 11/24, G01L 19/14, G01L 19/00

(54) **Vorrichtung zur Erfassung und Verarbeitung von Sensormesswerten und/oder zur Steuerung von Aktuatoren**
Device for the recording and processing of sensor measurement values and/or for controlling actuators
Dispositif destiné à l'enregistrement et au traitement de valeurs de mesure de capteur et/ou à la commande d'actionneurs

(30) Priorität: 19.07.2012 DE 102012014407
(43) Veröffentlichungstag der Anmeldung: 22.01.2014
(73) Patentinhaber: ZF CV Systems Europe BV, 1170 Brüssel (BE)
(72) Erfinder: Bolik, Thomas, 30559 Hannover (DE); Feyerabend, Konrad, 30625 Hannover (DE); Hansen, Yves, 30519 Hannover (DE); Heider, Joachim, 31226 Peine (DE); Hein, Joachim, 30539 Hannover (DE); Rüter, Rodmar, 30938 Burgwedel (DE)
(74) Vertreter: Eisenführ Speiser

(56) Entgegenhaltungen:
- EP-A1- 1 207 379
- WO-A1-2010/083047
- CA-A1- 2 366 999
- DE-A1- 10 036 086
- DE-A1- 19 837 640
- DE-A1- 19 917 941
- DE-A1-102005 059 941
- DE-A1-102010 063 709
- DE-B3-102006 036 096
- DE-C1- 19 811 610
- GB-A- 2 282 366

## Beschreibung

Die Erfindung betrifft eine Vorrichtung zur Erfassung und Verarbeitung von Sensormesswerten und/oder zur Steuerung von Aktuatoren, mit einem Basisgehäuse, mit an dem Basisgehäuse befestigten Sensoren und/oder Aktuatoren, mit einem Deckel, welcher mit dem Basisgehäuse die Sensoren und/oder Aktuatoren abdeckend verbindbar ist, und mit einer eine Steuerelektronik aufweisende Leiterplatte.

Ein Anwendungsbereich für eine solche Vorrichtung kann ein Fahrzeugbremssystem sein, bei denen zwischen dem Bremsbetätigungspedal und dem Hauptbremszylinder des Bremsaggregates keine mechanische Kopplung besteht. Die Hauptkenngrößen zur Regelung derartiger Bremssysteme bilden die in der Fluiddruckanlage, also den Bremskreisen auftretenden Betriebsdrücke, die von Drucksensoren erfasst und in elektrische Messwerte umgewandelt werden. Eine Steuerelektronik wertet diese Messwerte zusammen mit anderen Sensorsignalen aus und generiert entsprechende Ansteuerungssignale für einen Aktuator des Bremsaggregats.

Bei herkömmlichen Druckmesssystemen bilden die Sensoren in einer Ausführungsform einen Teil der jeweiligen Steuerelektronik und sind mit deren Leiterplatte mechanisch und elektrisch verbunden. Ein wesentlicher Nachteil derartiger Vorrichtungen wird darin gesehen, dass auch dann, wenn nur die Elektronik oder nur die Sensoren ausfallen, jeweils Elektronik und Sensoren gemeinsam ausgetauscht werden müssen, was zu entsprechend hohen Kosten führt.

Aus der DE 199 17 941 A1 ist bereits ein Bremsgerät für Fahrzeugbremssysteme mit einem Druckmesssystem der im Oberbegriff des Anspruchs 1 genannten Art bekannt, bei welchem ein oder mehrere Drucksensoren jeweils fest mit einem den Fluiddruck führenden Basisgehäuse bzw. Hydraulikblock verbunden sind, während die Steuerelektronik zur Messwertauswertung und Steuersignalgenerierung offensichtlich jeweils auf die einzelnen Drucksensoren aufgeteilt in über die Drucksensoren gestülpten domartigen Gehäusen angeordnet ist. Der jeweils einem Drucksensor zugeordnete Teil der Steuerelektronik ist in entsprechend gestalteten Aufnahmen der Gehäuse untergebracht und mit gesonderten, in nicht näher dargestellter Weise mit der Steuerelektronik kontaktierten, in einem Stanzgitterträger angeordneten Kontaktflächen verbunden, an die sich Kontaktfedern beim Aufsetzen der Gehäuse anlegen. Aus DE 10 2005 059 941 ist eine Druckregelvorrichtung für Kraftfahrzeugbremsen bekannt, mit einem auf der Deckeloberseite angebrachten Anschlussstecker, der mehrere Pins aus leitfähigem Material aufweist, welche direkt als Einpresskontake in geeignete Bohrungen einer Leiterplatte geführt sind.

Diese bekannte Anordnung erlaubt zwar bereits einen getrennten Austausch von Drucksensor und Steuerelektronik, sie ist jedoch insbesondere dann, wenn eine Vielzahl von Drucksensoren vorgesehen ist, herstellungstechnisch und montagetechnisch aufwendig und teuer, da die den Drucksensoren zugeordneten Teile der Steuerelektronik einzeln in die diesen zugeordneten Gehäuse montiert und jedenfalls danach zu einer Gesamt-Steuerelektronik miteinander verbunden werden müssen. Um die Steuerelektronik nicht mit den Druckkräften der Kontaktfedern zu belasten, sind zusätzlich die gesonderten, in einem Stanzgitter angeordneten und mechanisch für die Aufnahme der Druckkräfte ausgelegten Kontaktflächen vorgesehen, was diese Anordnung weiter verkompliziert.

Vor diesem Hintergrund liegt der Erfindung die Aufgabe zugrunde, eine Vorrichtung der im Oberbegriff des Anspruchs 1 genannten Art vorzustellen, welche herstellungstechnisch und montagetechnisch erheblich einfacher und damit kostengünstiger ist.

Die Lösung dieser Aufgabe ergibt sich aus den Merkmalen des Hauptanspruchs, während vorteilhafte Ausgestaltungen und Weiterbildungen der Erfindung den Unteransprüchen entnehmbar sind.

Der Erfindung liegt die Erkenntnis zugrunde, dass sich die Herstellung und Montage erheblich vereinfachen lassen, wenn unabhängig von der Anzahl der verwendeten Drucksensoren oder auch Aktuatoren, also insbesondere bei einer Vorrichtung mit mehreren Drucksensoren und Aktuatoren, die Steuerelektronik und der Deckel der Vorrichtung zu einem Bauteil zusammengefasst werden, also etwa im Sinne eines Vormontagebauteils.

Demnach geht die Erfindung aus von einer Vorrichtung zur Erfassung und Verarbeitung von Sensormesswerten und/oder zur Steuerung von Aktuatoren, mit einem Basisgehäuse, mit an dem Basisgehäuse befestigten Sensoren und/oder Aktuatoren, mit einem Deckel, welcher mit dem Basisgehäuse die Sensoren und/oder Aktuatoren abdeckend verbindbar ist, und mit einer eine Steuerelektronik aufweisende Leiterplatte.

Zur Lösung der gestellten Aufgabe ist dabei vorgesehen, dass die Leiterplatte über Press-Fit-Verbindungsmittel mit der Innenseite des Deckels fest verbunden ist, dass die Leiterplatte an ihrer deckelfernen Seite elektrisch wirksame erste Kontaktflächen aufweist, dass die Sensoren und/oder Aktuatoren an ihrer zum Deckel weisenden Seite elektrisch wirksame zweite Kontaktflächen aufweisen, und dass die zweiten Kontaktflächen der Sensoren und/oder Aktuatoren über elektrisch leitende Kontaktfedern mit den ersten Kontaktflächen auf der Leiterplatte in Verbindung stehen.

Ein wesentlicher Vorteil der erfindungsgemäßen Anordnung ergibt sich aus der Ausbildung der gedruckten Leiterplatte mit ihren direkt kontaktierbaren Kontaktflächen sowie aus der Montage der Leiterplatte an dem Deckel mittels der an sich bekannten Press-Fit-Verbindungsmittel. Diese Press-Fit-Verbindungsmittel ermöglichen eine einfache Verbindung der Leiterplatte mit dem Deckel. Da die Leiterplatte direkt kontaktierbar ausgebildet ist, entfallen gesonderte, mit der Leiterplatte elektrisch durch Lötstellen zu verbindende Leitungen zu den Sensoren und/oder Aktuatoren.

Gemäß der Erfindung ist vorgesehen, dass zumindest einige der Press-Fit-Verbindungsmittel genau gegenüber den Kontaktflächen der Leiterplatte an derselben angeordnet sind. Dadurch werden die von den Kontaktfedern auf die Leiterplatte ausgeübten Druckkräfte durch dieselbe hindurch in die Press-Fit-Verbindungsmittel und von dort in den Deckel geleitet, so dass die Leiterplatte keine Durchbiegung durch die Druckkräfte der Kontaktfedern erfährt.

Zusätzlich kann zur Erfüllung des gleichen Zwecks vorgesehen sein, dass der Deckel an seiner Innenseite nach innen, also in Richtung zu den Sensoren und/oder Aktuatoren, abstehende Stützvorsprünge aufweist, an denen sich die Leiterplatte im montiertem Zustand zusätzlich abstützt. Die vorgeschlagene Konstruktion stützt demnach über die Press-Fit-Verbindungsmittel, die Stützvorsprünge und die Kontaktfedern die Leiterplatte beidseitig an mehreren Stellen ab, so dass diese vorteilhaft kaum zu nachteiligen Schwingungen anregbar ist.

Die Sensoren können beispielsweise als Drucksensoren, Temperatursensoren, Beschleunigungssensoren oder Feuchtesensoren ausgebildet sein, und die Aktuatoren sind vorzugsweise so ausgebildet, dass sie Fluidströme steuern und regeln können.

Weitere Vorteile ergeben sich insbesondere für eine Anordnung, bei der die Vorrichtung mehrere Sensoren und/oder Aktuatoren aufweist. Für diesen Fall ist erfindungsgemäß vorgesehen, dass die Steuerelektronik für alle Sensoren und/oder Aktuatoren auf einer einzigen Leiterplatte angeordnet ist, die wie beschrieben an der Innenseite des Deckels befestigt ist. Auf diese Weise kann die Kontaktierung aller Sensoren und/oder Aktuatoren gleichzeitig durch Aufsetzen des Deckels auf das Basisgehäuse bewerkstelligt werden. Dennoch bleibt es möglich, einzelne Sensoren und/oder Aktuatoren bei Bedarf nach Abnahme des Deckels auszutauschen.

Eine andere Weiterbildung der Vorrichtung sieht vor, dass die jeweiligen Sensoren eine Sensormesszelle und eine dieser zugeordneten Elektronik aufweist, wobei die Sensormesszellen des jeweiligen Sensors in einem gemeinsamen Sensorgehäuse angeordnet sind. Das sensorseitige zylindrische Ende der Kontaktfedern ist hierbei bevorzugt in einer zugeordneten zylindrischen Durchgangsbohrung aufgenommen, wobei die jeweilige Durchgangsbohrung einer elektrischen Kontaktfläche der Sensormesszelle zugeordnet ist.

Um die jeweilige Kontaktfeder in der Durchgangsbohrung festzuhalten und dadurch gegen ein Herausfallen zu sichern, ist bevorzugt vorgesehen, dass der Außendurchmesser des zylindrischen sensorseitigen Endes der Kontaktfedern an den Durchmesser der zylindrischen Durchgangsbohrungen so angepasst ist, dass die Kontaktfedern in den zugeordneten Durchgangsbohrungen festgehalten werden. Dazu haben die Kontaktfedern an ihrem sensorseitigen Ende gegenüber dem Durchmesser der Durchgangsbohrungen ein für diesen Zweck ausreichend dimensioniertes Durchmesserübermaß, welches jedoch immer noch ein vergleichsweise leichtes Einstecken derselben in die zugeordnete Durchgangsbohrung ermöglicht.

Gemäß einer weiteren Ausgestaltung der Erfindung sind die Sensoren und/oder Aktuatoren mechanisch mittels Halteklammern am Basisgehäuse befestigt. Dann, wenn der jeweilige Sensor als Drucksensor bzw. der Aktuator als ein einen Fluidstrom steuernder oder regelnder Aktuator ausgebildet ist, sind diese fluidtechnisch mittels eines Druckschlauches oder mittels einer metallischen Druckleitung mit einem Druckfluid führenden Raum des Basisgehäuses verbunden. Diese Maßnahme ermöglicht einen einfachen Austausch einzelner Drucksensoren und/oder Aktuatoren.

Weiter kann vorgesehen sein, dass eine Druckmesszelle eines Drucksensors als Keramikkörper mit auf diesem angeordneten Dehnungsmessstreifen ausgebildet ist, und dass die Kontaktfläche des Drucksensors für die Kontaktfeder direkt auf der Druckmesszelle angeordnet ist.

Gemäß einer anderen Variante können die Drucksensoren auch jeweils als Druckdose ausgebildet sein, deren Gestaltänderung bei Druckänderung in geeigneter Weise auf die zugeordnete Elektronik übertragen wird.

Die Erfindung wird nachfolgend anhand eines Ausführungsbeispiels weiter erläutert. Dazu ist der Beschreibung eine Zeichnung beigefügt. In dieser zeigt
Fig. 1 schematisch eine teilweise geschnittene Seitenansicht eine Vorrichtung zur Erfassung und Verarbeitung von Messwerten eines Drucksensors und zur Steuerung eines Aktuators, sowie
Fig. 2 in einer teilweise geschnittenen Seitenansicht eine Einzelheit eines Drucksensors gemäß Fig. 1.

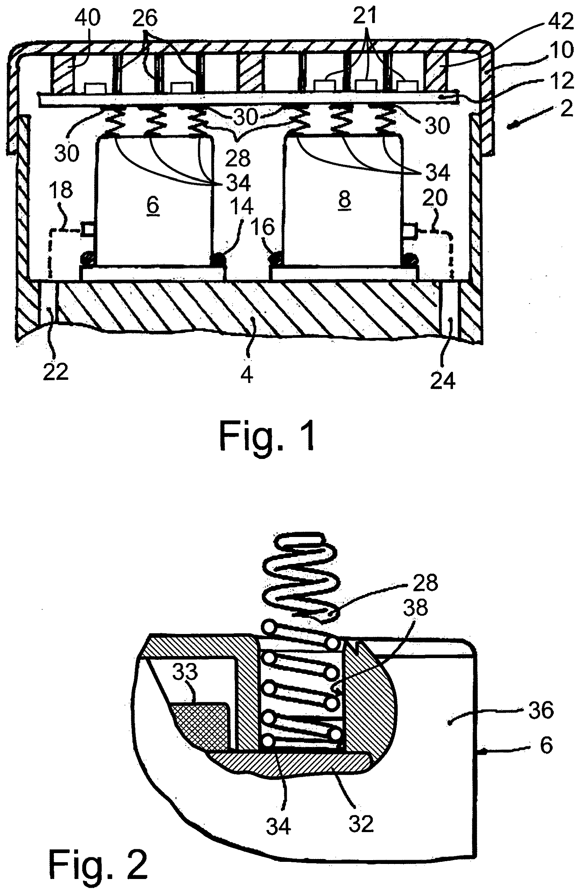

Die in Fig. 1 dargestellte Vorrichtung 2 weist ein einen Fluiddruck führendes Basisgehäuse 4 auf, welches auch als Hydraulikblock bzw. Pneumatikblock bezeichnet werden kann, ferner einen mit dem Basisgehäuse 4 fest verbundenen, einen Fluiddruck aufnehmenden Drucksensor 6, einen einen Fluidstrom steuernder oder regelnder Aktuator 8 und einen auf das Basisgehäuse 4 aufgesetzten Deckel 10, in dem eine gedruckte Leiterplatte 12 angeordnet ist, welche eine aus elektronischen Bauelementen bestehende Steuerelektronik 21 trägt.

Der Drucksensor 6 und der Aktuator 8 sind an dem Basisgehäuse 4 in nicht näher dargestellter Weise mittels Halteklammern 14 bzw. 16 befestigt. Fluidtechnisch ist der Drucksensor 6 mittels eines Druckschlauches 18 mit einem Druckfluid führenden ersten Kanal 22 des Basisgehäuses 4 verbunden. Der Aktuator 8 steht über eine Leitung 20 mit einem zugeordneten zweiten Kanal 24 im Basisgehäuse 4 in Verbindung.

Die gedruckte Leiterplatte 12 ist an dem Deckel 10 angeordnet und an dessen Innenseite mittels Press-Fit-Verbindungsmittel 26 mechanisch fixiert. Außerdem weist der Deckel 10 an seiner Innenseite mehrere Stützvorsprünge 40, 42 auf, auf denen die Leiterplatte 12 aufliegt.

Der elektrische Kontakt zwischen dem Drucksensor 6 bzw. dem Aktuator 8 einerseits und der die Steuerelektronik 21 tragenden Leiterplatte 12 andererseits erfolgt über jeweils zugeordnete Kontaktfedern 28, die zwischen der Leiterplatte 12 und dem Drucksensor 6 bzw. dem Aktuator 8 angeordnet sind. Dabei stützen sich die Kontaktfedern 28 leiterplattenseitig direkt auf erste elektrische Kontaktflächen 30 ab, die deckelfern an auf der Leiterplatte 12 ausgebildet sind. Wie Fig. 1 zeigt, sind die Press-Fit-Verbindungsmittel 26 an der deckelnahen Seite der Leiterplatte 12 genau gegenüber den ersten elektrischen Kontaktflächen 30 bzw. genau gegenüber den Kontaktfedern 28 angeordnet, so dass diese die von den Kontaktfedern 28 auf die Leiterplatte 12 ausgeübte Kraft aufnehmen und an den Deckel 10 weiterleiten können. Die Kontaktfedern 26 liegen auf ebenfalls zugeordnete zweite elektrische Kontaktflächen 34 an den Sensoren 6 bzw. Aktuatoren 8 auf, wie nachfolgend noch weiter erläutert wird.

Der Drucksensor 6 und der Aktuator 8 haben in Teilen einen herkömmlichen Aufbau. Demnach weist der Drucksensor 6 eine Druckmesszelle 32 und eine dieser Druckmesszelle 32 zugeordnete Elektronik 33 zur Umwandlung der aufgenommenen Fluiddrücke in elektrische Messsignale auf. Die Druckmesszelle 32 ist beispielsweise ein Keramikkörper, an welchem Dehnungsmessstreifen angeordnet sind, deren bei unterschiedlichen Drücken unterschiedliche Dehnungen ein Maß für den Fluiddruck bilden. Gemäß einer anderen Ausgestaltung ist der Drucksensor als Druckdose ausgebildet, dessen Formänderung bei einer Druckänderung ebenfalls ein Maß für den gemessenen Druck darstellt.

Fig. 2 zeigt ein Detail des Drucksensors 6 mit einer darin angeordneten Druckmesszelle 32 aus einem Keramikwerkstoff und einer zugeordneten sensorseitigen Elektronik 33 zur Umwandlung des aufgenommenen Fluiddrucks in ein elektrisches Messsignal. Eine zweite elektrische Kontaktfläche 34 ist direkt auf der Druckmesszelle 32 angeordnet. Im Bereich der zweiten elektrischen Kontaktfläche 34 ist in der Deckwand des Sensorgehäuses 36 eine zylindrische Durchgangsbohrung 38 ausgebildet, die eine im Aufnahmebereich weitgehend zylindrische Kontaktfeder 28 aufnimmt. Die Weite der Windungen des sensorseitigen Endes der Kontaktfeder 28 ist an die Geometrie und die Abmessungen der Durchgangsbohrung 38 derartig angepasst, dass die Kontaktfeder 28 in der Durchgangsbohrung 38 sicher fixiert ist. Hierzu weist das sensorseitige Ende der Kontaktfeder 28 beispielsweise ein sehr geringes Übermaß gegenüber dem Durchmesser der Durchgangsbohrung 38 auf. Die Fixierung des sensorseitigen Endes der Kontaktfeder 28 dient lediglich als Verliersicherung während eines Zusammenbauvorgangs der Gesamtvorrichtung 2.

Wie sich aus Vorstehendem ergibt, erfolgt die elektrische Kontaktierung der Leiterplatte 12 mit allen Sensoren 6 und Aktuatoren 8 beim Aufsetzen des Deckels 10 auf das Basisgehäuse 4 automatisch. Ein Austausch eines defekten Sensors 6 oder Aktuators 8 ist nach Abnehmen des Deckels 10 vom Basisgehäuse 4 ohne weiteres und mit geringem Aufwand möglich.

## Patentansprüche

1. Vorrichtung (2) zur Erfassung und Verarbeitung von Sensormesswerten und/oder zur Steuerung von Aktuatoren (8), mit einem Basisgehäuse (4), mit an dem Basisgehäuse (4) befestigten Sensoren (6) und/oder Aktuatoren (8), mit einem Deckel (10), welcher mit dem Basisgehäuse (4) die Sensoren (6) und/oder Aktuatoren (8) abdeckend verbindbar ist, und mit einer eine Steuerelektronik (21) aufweisende Leiterplatte (12),
**dadurch gekennzeichnet,**
**dass** die Leiterplatte (12) über Press-Fit-Verbindungsmittel (26) mit der Innenseite des Deckels (10) fest verbunden ist,
**dass** die Leiterplatte (12) an ihrer deckelfernen Seite elektrisch wirksame erste Kontaktflächen (30) aufweist,
**dass** die Sensoren (6) und/oder Aktuatoren (8) an ihrer zum Deckel (10) weisenden Seite elektrisch wirksame zweite Kontaktflächen (34) aufweisen,
**dass** die zweiten Kontaktflächen (34) der Sensoren (6) und/oder Aktuatoren (8) über elektrisch leitende Kontaktfedern (28) mit den ersten Kontaktflächen (30) in Verbindung stehen, und
**dass** zumindest einige der Press-Fit-Verbindungsmittel (26) genau gegenüber den ersten Kontaktflächen (30) der Leiterplatte (12) an derselben angeordnet sind.

2. Vorrichtung nach Anspruch 1, **dadurch gekennzeichnet, dass** der Deckel (10) an seiner Innenseite nach innen abstehende Stützvorsprünge (40, 42) aufweist, an denen sich die Leiterplatte (12) im montiertem Zustand abstützt.

3. Vorrichtung nach einem der Ansprüche 1 bis 2, **dadurch gekennzeichnet, dass** die Sensoren (6) als Drucksensoren, Temperatursensoren, Beschleunigungssensoren oder Feuchtesensoren ausgebildet sind.

4. Vorrichtung einem der vorherigen Ansprüche 1 bis 2, **dadurch gekennzeichnet, dass** die Aktuatoren (8) so ausgebildet sind, dass sie Fluidströme steuern und regeln können.

5. Vorrichtung nach einem der vorherigen Ansprüche, **dadurch gekennzeichnet, dass** eine Sensormesszelle (32) und eine dieser zugeordnete Elektronik (33) in einem gemeinsamen Sensorgehäuse (36) angeordnet sind, und dass das zylindrische sensorseitige Ende der Kontaktfeder (28) in einer zylindrischen Durchgangsbohrung (38) aufgenommen ist, wobei die Durchgangsbohrung (38) einer Kontaktfläche (34) der Sensormesszelle (32) zugeordnet ist.

6. Messsystem nach Anspruch 5, **dadurch gekennzeichnet, dass** der Außendurchmesser des zylindrischen sensorseitigen Endes der Kontaktfeder (28) an den Durchmesser der zylindrischen Durchgangsbohrung (38) so angepasst ist, dass die Kontaktfeder (28) in der zugeordneten Durchgangsbohrung (38) verliersicher festgehalten wird.

7. Messsystem nach einem der vorherigen Ansprüche, **dadurch gekennzeichnet, dass** die Sensoren (6) und/oder Aktuatoren (8) mittels Halteklammern (14, 16) am Basisgehäuse (4) befestigt sind.

8. Messsystem nach einem der vorherigen Ansprüche, **dadurch gekennzeichnet, dass** der wenigstens eine Sensor (6) als Drucksensor ausgebildet sowie fluidtechnisch mittels eines Druckschlauchs (18, 20) oder einer metallischen Druckleitung mit einem Druckfluid führenden Kanal (22, 24) des Basisgehäuses (4) verbunden ist.

9. Messsystem nach einem der vorherigen Ansprüche, **dadurch gekennzeichnet, dass** die Druckmesszelle (32) als Keramikkörper mit auf diesem angeordneten Dehnungsmessstreifen ausgebildet ist.

10. Messsystem einem der vorherigen Ansprüche, **dadurch gekennzeichnet, dass** die Kontaktfläche (34) des Drucksensors (6) für die zugeordnete Kontaktfeder (28) direkt auf der Druckmesszelle (32) angeordnet ist.

## Claims

1. Device (2) for acquiring and processing sensor measured values and/or for controlling actuators (8), having a base housing (4), having sensors (6) and/or actuators (8) which are attached to the base housing (4), having a cover (10) which can be connected to the base housing (4) so as to cover the sensors (6) and/or actuators (8), and having a circuit board (12) which has control electronics (21), **characterized in that** the circuit board (12) is permanently connected to the inner side of the cover (10) using press fit connecting means (26), **in that** the circuit board (12) has electrically active first contact faces (30) on its side remote from the cover, **in that** the sensors (6) and/or actuators (8) have electrically active second contact faces (34) on their side pointing to the cover (10), **in that** the second contact faces (34) of the sensors (6) and/or actuators (8) are connected to the first contact faces (30) via electrically conductive contact springs (28), and **in that** at least some of the press fit connecting means (26) are arranged on the circuit board (12), precisely with respect to the first contact faces (30) of said circuit board (12).

2. Device according to Claim 1, **characterized in that** the cover (10) has, on its inner side, inwardly protruding supporting projections (40, 42) on which the circuit board (12) is supported in the mounted state.

3. Device according to either of Claims 1 and 2, **characterized in that** the sensors (6) are embodied as pressure sensors, temperature sensors, acceleration sensors or moisture sensors.

4. Device according to either of the preceding Claims 1 and 2, **characterized in that** the actuators (8) are embodied in such a way that they can perform open loop and closed loop control on fluid flows.

5. Device according to one of the preceding claims, **characterized in that** a sensor measuring cell (32) and electronics (33) assigned thereto are arranged in a common sensor housing (36) and **in that** the cylindrical sensor side end of the contact spring (28) is accommodated in a cylindrical continuous bore (38), wherein the continuous bore (38) is assigned to a contact face (34) of the sensor measuring cell (32).

6. Measuring system according to Claim 5, **characterized in that** the external diameter of the cylindrical sensor side end of the contact spring (28) is adapted to the diameter of the cylindrical continuous bore (38) in such a way that the contact spring (28) is secured captively in the assigned continuous bore (38).

7. Measuring system according to one of the preceding claims, **characterized in that** the sensors (6) and/or actuators (8) are attached to the base housing (4) by means of securing clamps (14, 16).

8. Measuring system according to one of the preceding claims, **characterized in that** the at least one sensor (6) is embodied as a pressure sensor and is connected fluidically by means of a pressure hose (18, 20) or a metallic pressure line to a duct (22, 24) of the base housing (4) which conducts hydraulic fluid.

9. Measuring system according to one of the preceding claims, **characterized in that** the pressure measuring cell (32) is embodied as a ceramic body with strain gauge strips arranged thereon.

10. Measuring system according to one of the preceding claims, **characterized in that** the contact face (34) of the pressure sensor (6) for the assigned contact spring (28) is arranged directly on the pressure measuring cell (32).

## Revendications

1. Dispositif (2) de détection et de traitement de valeurs de mesure de capteurs et/ou de commande d'actionneurs (8), ledit dispositif comportant un boîtier de base (4), des capteurs (6) et/ou des actionneurs (8) fixés sur le boîtier de base (4), un couvercle (10) qui peut être relié au boîtier de base (4) de manière à recouvrir les capteurs (6) et/ou les actionneurs (8), et une carte de circuit imprimé (12) comportant une électronique de commande (21), **caractérisé en ce que**
la carte de circuit imprimé (12) est reliée de manière fixe par l'intermédiaire de moyens de connexion ajustés par pression (26) à la face interne du couvercle (10),
la carte de circuit imprimé (12) comporte, sur sa face éloignée du couvercle, des premières surfaces de contact électriquement actives (30),
les capteurs (6) et/ou les actionneurs (8) comportent, sur leur face tournée vers le couvercle (10), des deuxièmes surfaces de contact électriquement actives (34),
les deuxièmes surfaces de contact (34) des capteurs (6) et/ou des actionneurs (8) sont reliées aux premières surfaces de contact (30) par l'intermédiaire de ressorts de contact électriquement conducteurs (28), et **en ce qu'**au moins certains des moyens de connexion ajustés par pression (26) sont disposés sur la carte de circuit imprimé (12) exactement en face des premières surfaces de contact (30) de celle-ci.

2. Dispositif selon la revendication 1, **caractérisé en ce que** le couvercle (10) comporte sur sa face interne des protubérances de support (40, 42) qui font saillie vers l'intérieur et sur lesquelles s'appuie la carte de circuit imprimé (12) à l'état monté.

3. Dispositif selon l'une des revendications 1 à 2, **caractérisé en ce que** les capteurs (6) sont réalisés sous la forme de capteurs de pression, de capteurs de température, de capteurs d'accélération ou de capteurs d'humidité.

4. Dispositif selon l'une des revendications 1 à 2 précédentes, **caractérisé en ce que** les actionneurs (8) sont réalisés de manière à pouvoir commander et réguler des flux de fluide.

5. Dispositif selon l'une des revendications précédentes, **caractérisé en ce qu'**une cellule de mesure de capteur (32) et une électronique (33) associée à celle-ci sont disposées dans un boîtier de capteur commun (36), et **en ce que** l'extrémité cylindrique côté capteur du ressort de contact (28) est logée dans un trou traversant cylindrique (38), le trou traversant (38) étant associé à une surface de contact (34) de la cellule de mesure de capteur (32).

6. Système de mesure selon la revendication 5, **caractérisé en ce que** le diamètre extérieur de l'extrémité cylindrique côté capteur du ressort de contact (28) est adapté au diamètre du trou traversant cylindrique (38) afin que le ressort de contact (28) soit maintenu de manière imperdable dans le trou traversant (38) associé.

7. Système de mesure selon l'une des revendications précédentes, **caractérisé en ce que** les capteurs (6) et/ou les actionneurs (8) sont fixés au moyen de brides de retenue (14, 16) au boîtier de base (4).

8. Système de mesure selon l'une des revendications précédentes, **caractérisé en ce que** l'au moins un capteur (6) est réalisé sous la forme d'un capteur de pression et est relié fluidiquement au moyen d'un tuyau de pression (18, 20) ou d'une conduite de pression métallique à un conduit d'acheminement de fluide sous pression (22, 24) du boîtier de base (4).

9. Système de mesure selon l'une des revendications précédentes, **caractérisé en ce que** la cellule de mesure de pression (32) est réalisée sous la forme d'un corps céramique sur lequel est disposée une jauge de contrainte.

10. Système de mesure selon l'une des revendications précédentes, **caractérisé en ce que** la surface de contact (34) du capteur de pression (6) destinée au ressort de contact (28) associé est disposée directement sur la cellule de mesure de pression (32).
